# EUROPEAN PATENT SPECIFICATION

(11) **EP 1 734 623 B1**
(45) Date of publication and mention of the grant of the patent: **23.01.2008**
(21) Application number: 06010266.2
(22) Date of filing: 18.05.2006
(51) Int. Cl.: H01S 5/042, H01S 5/026

(54) **Surface emitting laser integrated with rectification element**
Oberflächenemittierender Laser mit integriertem gleichrichtenden Element
Laser à émission de surface avec élément de redressage integré

(30) Priority: 17.06.2005 JP 2005177637
(43) Date of publication of application: 20.12.2006
(73) Proprietor: Seiko Epson Corporation, Tokyo 160-0811 (JP)
(72) Inventor: Kaneko, Tsuyoshi, Suwa-shi, Nagano-ken 392-8502 (JP)
(74) Representative: Hoffmann, Eckart

(56) References cited:
- EP-A- 0 933 842
- US-A- 5 404 373
- US-A- 5 541 443
- US-A1- 2003 228 716
- PATENT ABSTRACTS OF JAPAN vol. 2003, no. 12, 5 December 2003 (2003-12-05) & JP 2004 311701 A (SEIKO EPSON CORP), 4 November 2004 (2004-11-04)

## Description

### BACKGROUND

### Technical Field

The present invention relates to optical elements.

### Related Art

An optical element, such as, an emission diode, a surface-emitting type semiconductor laser, and a photo diode has a structure in which an edge section thereof has step differences because a columnar section is formed for defining a light emission or light reception region. Also, in areas where insulation films, bonding pads and the like are formed, an optical element has a structure with step differences. There is a problem in that electrodes of the optical element would likely be disconnected in the areas with a structure having step differences.

Japanese Laid-open Patent Application JP-A-2004-311701 describes a method for preventing disconnection of electrodes by forming the side surface of an element in a positively tapered configuration.

US-A-5 404 373 discloses an optical element according to the preamble of claim 1.

### SUMMARY

In accordance with an advantage of some aspects of the present invention, it is possible to provide an optical element that can prevent the reliability of the optical element from being lowered by disconnection of electrodes.

An optical element in accordance with an embodiment of the invention includes: a first semiconductor element and a second semiconductor element, wherein the first semiconductor element includes a semiconductor layer, first and second electrodes of a first conductivity type for driving the first semiconductor element, formed at mutually separated positions and above the semiconductor layer, a third electrode of a second conductivity type for driving the first semiconductor element, and the second semiconductor element includes a fourth electrode of the first conductivity type for driving the second semiconductor element, and a fifth electrode of the second conductivity type for driving the second semiconductor element. The optical element is further equipped with a connection electrode for connecting the first electrode and the fifth electrode, and for connecting the second electrode and the fifth electrode.

In this manner, the fifth electrode of the second semiconductor element is electrically connected by the connection electrode to the first semiconductor element at a plurality of positions, such that the first semiconductor element and the second semiconductor element can both be functioned even when one of the connections is disconnected, and therefore the reliability of the optical element can be improved.

In the optical element in accordance with an aspect of the embodiment of the invention, the first electrode and the second electrode, and the fifth electrode may be formed at different heights, and the connection electrode may be formed continuously over a substrate from an upper surface of the first electrode to an upper surface of the fifth electrode, and formed continuously from an upper surface of the second electrode to an upper surface of the fifth electrode.

In this manner, even when the first electrode and the second electrode, and the fifth electrode are formed at different heights, disconnection can be prevented by continuously forming them in multiple directions.

The optical element in accordance with an aspect of the embodiment of the invention may further include an insulation layer formed between the first semiconductor element and the second semiconductor element, wherein the connection electrode may be formed through an upper surface of the insulation layer continuously from the upper surface of the first electrode to the upper surface of the fifth electrode, and formed through the upper surface of the insulation layer continuously from the upper surface of the second electrode to the upper surface of the fifth electrode.

In the optical element in accordance with an aspect of the embodiment of the invention, the first electrode and the second electrode may be formed at a position higher than the fifth electrode as viewed from the substrate side, and the insulation layer has a side surface downwardly sloped from the side of the first electrode and the second electrode to the side of the fifth electrode.

In the optical element in accordance with an aspect of the embodiment of the invention, the first electrode and the second electrode may be formed on an upper surface of the semiconductor layer, and the semiconductor layer may be formed in a region that does not include at least a part of a region over a virtual line connecting the first electrode and the second electrode, as viewed in a plan view.

In the optical element in accordance with an aspect of the embodiment of the invention, the connection electrode may be formed through a region other than a forming region of the semiconductor layer continuously from the upper surface of the first electrode to the upper surface of the second electrode.

In the optical element in accordance with an aspect of the embodiment of the invention, the second semiconductor element may be a surface-emitting type semiconductor laser. In the optical element in accordance with an aspect of the embodiment of the invention, the first semiconductor element may be a rectification element that is electrically connected in parallel with the surface-emitting type semiconductor laser.

An optical element in accordance with another embodiment of the invention includes a surface-emitting type semiconductor laser and a rectification element that is connected in parallel with the surface-emitting type semiconductor laser, wherein the rectification element includes a first semiconductor layer of a second conductivity type and a second semiconductor layer of a first conductivity type formed successively from the side of a substrate, a first electrode and a second electrode of the first conductivity type formed at mutually separated positions above the second semiconductor layer, and a third electrode of the second conductivity type, and the surface-emitting type semiconductor laser includes a first mirror, an active layer and a second mirror formed successively from the side of the substrate, a fourth electrode of the first conductivity type, and a fifth electrode of the second conductivity type. The optical element is further equipped with a connection electrode for connecting the first electrode and the fifth electrode, and for connecting the second electrode and the fifth electrode.

### BRIEF DESCRIPTION OF THE DRAWINGS

- FIG. 1: is a plan view schematically showing an optical element in accordance with an embodiment of the invention.
- FIG. 2: is a cross-sectional view schematically showing the optical element in accordance with the embodiment.
- FIG. 3: is a view showing a step of manufacturing an optical element in accordance with an embodiment of the invention.
- FIG. 4: is a view showing a step of manufacturing the optical element in accordance with the embodiment of the invention.
- FIG. 5: is a view showing a step of manufacturing the optical element in accordance with the embodiment of the invention.
- FIG. 6: is a view showing a step of manufacturing the optical element in accordance with the embodiment of the invention.
- FIG. 7: is a view showing a step of manufacturing the optical element in accordance with the embodiment of the invention.
- FIG. 8: is a view showing a step of manufacturing the optical element in accordance with the embodiment of the invention.
- FIG. 9: is a view showing a step of manufacturing the optical element in accordance with the embodiment of the invention.
- FIG. 10: is a view showing a step of manufacturing the optical element in accordance with the embodiment of the invention.

### DESCRIPTION OF EXEMPLARY EMBODIMENTS

A preferred embodiment of the invention is described below with reference to the accompanying drawings.

### 1. Structure of Optical Element

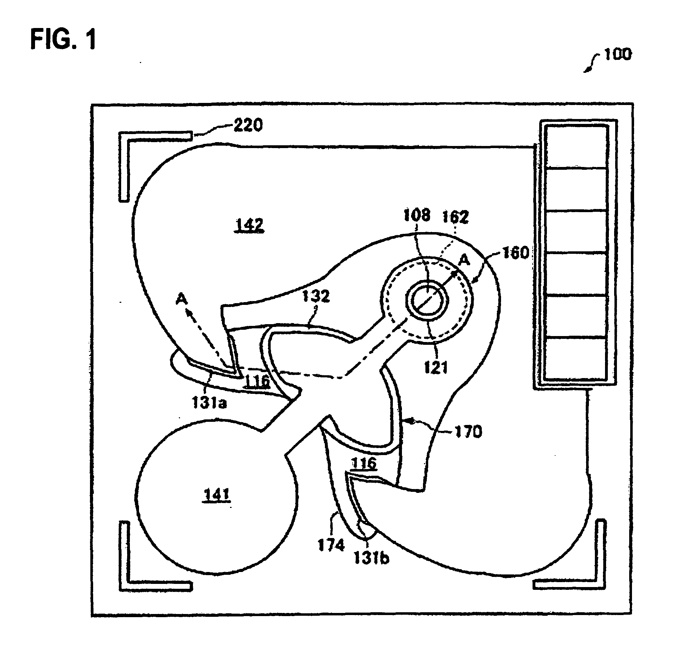

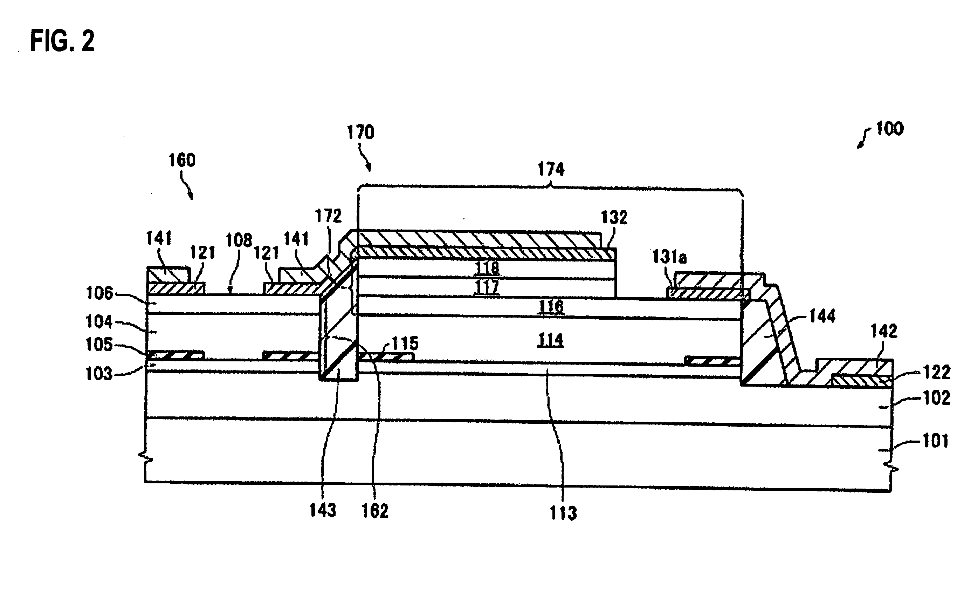

FIG. 1 is a plan view schematically showing an optical element 100 in accordance with an embodiment of the invention. FIG. 2 is a cross-sectional view schematically showing the optical element 100 in accordance with the embodiment of the invention. FIG. 2 is a view showing a cross section taken along a line A-A in FIG. 1.

The optical element 100 in accordance with the present embodiment includes, as shown in FIG. 1 and FIG. 2, a rectification element 170 that is an example of a first semiconductor element, a surface-emitting type semiconductor laser 160 that is an example of a second semiconductor element, a first connection electrode 141 and a second connection electrode 142 for connecting the surface-emitting type semiconductor laser 160 and the rectification element 170 in parallel with each other. The surface-emitting type semiconductor laser 160 and the rectification element 170 are formed over a common substrate (a semiconductor substrate 101).

The surface-emitting type semiconductor laser 160, the rectification element 170, and the overall structure of the element are described below.

### 1.1. Surface-Emitting Type Semiconductor Laser

The surface-emitting type semiconductor laser 160 has a vertical resonator. Also, the surface-emitting type semiconductor laser 160 may include a columnar semiconductor deposited body (hereafter referred to as a "columnar section") 162.

The surface-emitting type semiconductor laser 160 has a first mirror 102, an active layer 103, a second mirror 104, and a contact layer 106. As the first mirror, for example, a distributed Bragg reflection type mirror (DBR) of 40 pairs of alternately laminated n-type Al_{0.9}Ga_{0.1}As layers and n-type Al_{0.15} Ga_{0.85}As layers may be used. As the active layer 103, a layer composed of GaAs well layers and Al_{0.3}Ga_{0.7}As barrier layers in which the well layers include a quantum well structure composed of three layers can be used. As the second mirror 104, a distributed reflection type multilayer mirror of 25 pairs of alternately laminated p-type Al_{0.9}Ga_{0.1}As layers and p-type Al_{0.15} Ga_{0.85}As layers can be used. As the contact layer 106, for example, a p-type GaAs layer can be used. It is noted that the composition of each of the layers and the number of the layers described above are not limited to the above.

The second mirror 104 is made to be p-type, for example, by doping carbon (C), and the first mirror 102 is made to be n-type, for example, by doping silicon (Si). Accordingly, the p-type second mirror 104, the active layer 103 in which no impurity is doped, and the n-type first mirror 102 form a pin diode. It is noted that, in the present embodiment, the plane configuration of the columnar section 162 is circular, but can be in any arbitrary configuration.

A current constricting layer 105, which may be obtained by oxidizing an AlGaAs layer from its side surface, is formed in a region among the layers composing the second mirror 104 near the active layer 103. The current constricting layer 105 can have a ring shape along the circumference of the columnar section 162.

Also, the surface-emitting type semiconductor laser 160 further includes a p-type fourth electrode 121 and an n-type fifth electrode 122. The fourth electrode 121 is provided on the second mirror 104. The fourth electrode 121 may be formed, for example, in a ring shape, and its opening section functions as an emission surface 108 for a laser beam. The fifth electrode 122 is provided on the first mirror 102, and in a manner to surround the columnar section 162 below the second connection electrode 142. The fourth electrode 121 and the fifth electrode 122 are used for driving the surface-emitting type semiconductor laser 160.

### 1.2. Rectification Element

The rectification element may be composed of a junction diode, such as a pn junction diode, a Schottky barrier diode or the like, having a rectification action.

The rectification element 170 includes a first semiconductor layer 116, a second semiconductor layer 117, a third semiconductor layer 118, a first electrode 131 a, a second electrode 131b b and a third electrode 132, which are arranged in this order from the side of the semiconductor substrate 101.

The first semiconductor layer 116 has, as shown in FIG. 1, a shape that is bent as viewed in a plane view (i.e., a generally L-shape).

The second semiconductor layer 117 and the third semiconductor layer 118 are formed, as shown in FIG. 2, in a part of the area of the first semiconductor layer 116. Also, the second semiconductor layer 117 and the third semiconductor layer 118 are formed in an area that includes the center area of the first semiconductor layer 116, as viewed in a plan view. The first electrode 131a and the second electrode 131b b are formed in an area on the first semiconductor layer 116 where the second semiconductor layer 117 and the third semiconductor layer 118 are not formed. The first electrode 131a is formed at one of end sections on the first semiconductor layer 116, and the second electrode 131b is formed at the other end sections. The third electrode 132 is formed on the third semiconductor layer 118.

The first semiconductor layer 116 is composed of the same composition as that of the contact layer 106 described above. As the second semiconductor layer 117, for example, a GaAs layer in which no impurity is doped may be used. As the third semiconductor layer 118, for example, an n-type GaAs layer may be used.

Also, the rectification element 170 may include a fourth semiconductor layer 114 composed of the same composition as that of the second mirror 104 described above. In other words, the fourth semiconductor layer 114 may function as a part of the junction diode.

Also, the rectification element 170 is formed above a fifth semiconductor layer 113 composed of the same composition as that of the active layer 103 and the first mirror 102. In this manner, by forming the rectification element 170 above the layers for forming the surface-emitting type semiconductor laser 160, the rectification element 170 and the surface-emitting type semiconductor laser 160 can be monolithically formed.

The first electrode 131a and the second electrode 131b are electrodes having the same function, and formed at positions separated from each other. Also, the first semiconductor layer 116 is formed in a region that does not include at least a portion of an area on a virtual line connecting the first electrode 131a and the second electrode 131b, as viewed in a plan view. In other words, the first semiconductor layer 116 is bent, such that the first electrode 131 a and the second electrode 131b are formed at opposite end sections of the first semiconductor layer 116. The bent direction is the same as the bent direction of the second connection electrode 142, whereby the element area can be made smaller.

Moreover, because the first electrode 131a and the second electrode 131b are not provided on a linear first semiconductor layer 116, the stress caused by contraction of the first semiconductor layer 116 during the manufacturing step can be dispersed, whereby disconnection of the second connection electrode 142 can be prevented.

### 1.3 Overall Structure

As described above, the surface-emitting type semiconductor laser 160 and the rectification element 170 are connected in parallel with each other. In other words, the fourth electrode 121 of the surface-emitting type semiconductor laser 160 and the third electrode 132 of the rectification element 170 are electrically connected by the first connection electrode 141, and the fifth electrode 122 of the surface-emitting type semiconductor laser 160 and the first electrode 131a and the second electrode 131b of the rectification element 170 are electrically connected by the second connection electrode 142.

The first connection electrode 141 is formed continuously from the upper surface of the fourth electrode 121 to the upper surface of the third electrode 132. The fourth electrode 121 and the third electrode 132 are formed at mutually different heights. Moreover, because the surface-emitting type semiconductor laser 160 has the columnar section 162, and the rectification element 170 has a columnar section 174, a groove may be formed between the columnar section 162 and the columnar section 174. Accordingly, plural step differences are formed between the fourth electrode 121 and the third electrode 132, such that the first connection electrode 141 would like be disconnected above the step differences.

Therefore, in the optical element 100 in accordance with the present embodiment, a resin layer 143 that is an example of an insulation layer is formed between the columnar section 162 of the surface-emitting type semiconductor laser 160 and the columnar section 174 of the rectification element 170. The resin layer 143 has a downwardly sloped surface extending from the side of the third electrode 132 to the side of the fourth electrode 121, as shown in FIG. 2.

By this, the resin layer 143 covers the step differences formed along the first connection electrode 141 between the fourth electrode 121 and the third electrode 132, such that disconnection of the first connection electrode 141 can be prevented, which might occur if it passed directly on the plural step differences.

The second connection electrode 142 is formed continuously from the upper surface of the first electrode 131a and the second electrode 131 b to the upper surface of the fifth electrode 122. The second connection electrode 142, and the first electrode 131a and the second electrode 131b are formed at mutually different heights. Further, because the rectification element 170 has the columnar section 174, step differences are formed between the columnar section 174 and the fifth electrode 122. For this reason, the second connection electrode 142 would likely be disconnected above the step differences.

Therefore, in the optical element 100 in accordance with the present embodiment, a resin layer 144 that is an example of an insulation layer is formed between the first electrode 131a and the second electrode 131 b, and the fifth electrode 122. The resin layer 144 has a downwardly sloped surface extending from the side of the first electrode 131 a and the second electrode 131 b to the side of the fifth electrode 122, as shown in FIG. 2.

By this, the resin layer 144 covers the step differences formed along the second connection electrode 142 between the fifth electrode 122 and the first electrode 131a and the second electrode 131b, such that disconnection of the second connection electrode 142 can be prevented, which might occur if it passed directly on the plural step differences.

Also, the second connection electrode 142 connects to the fifth electrode 122 at two places. In other words, the second connection electrode 142 connects the first electrode 131a and the fifth electrode 122, and connects the second electrode 131b and the fifth electrode 122. By this, even when one of the connections is disconnected, the other maintains the electrical connection, such that the reliability of the optical element 100 can be improved.

### 2. Method for Manufacturing Optical Element

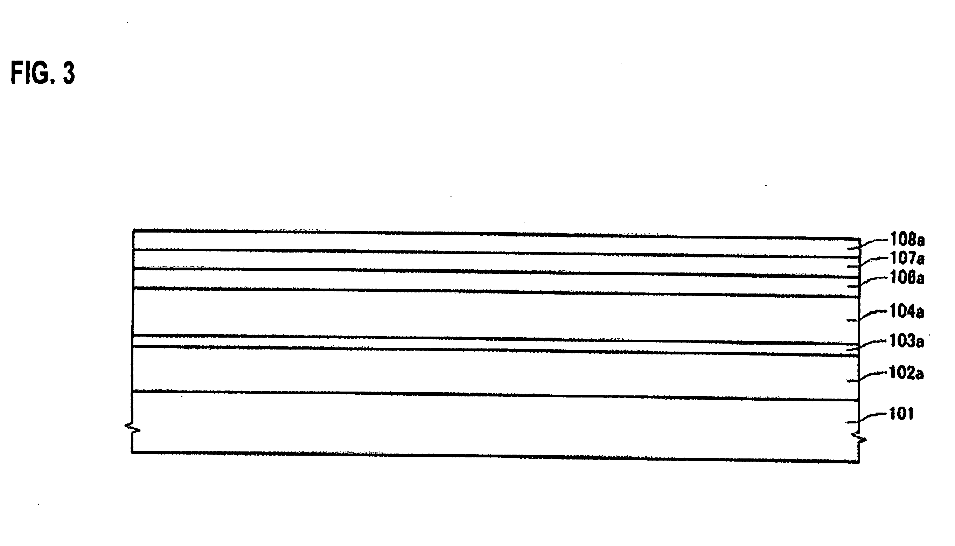

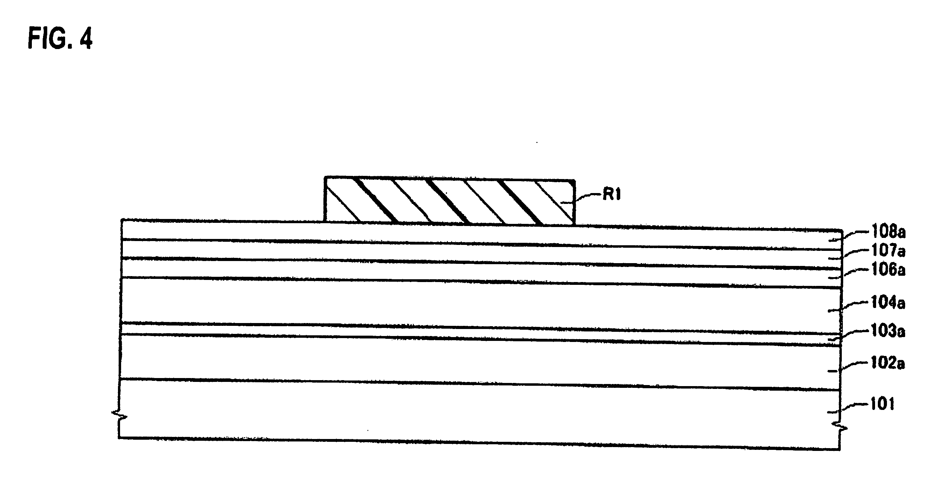

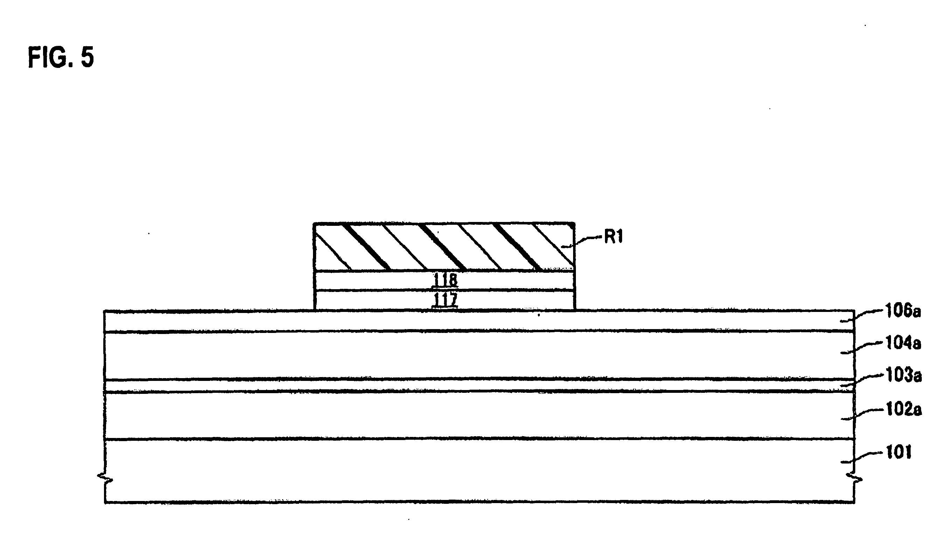

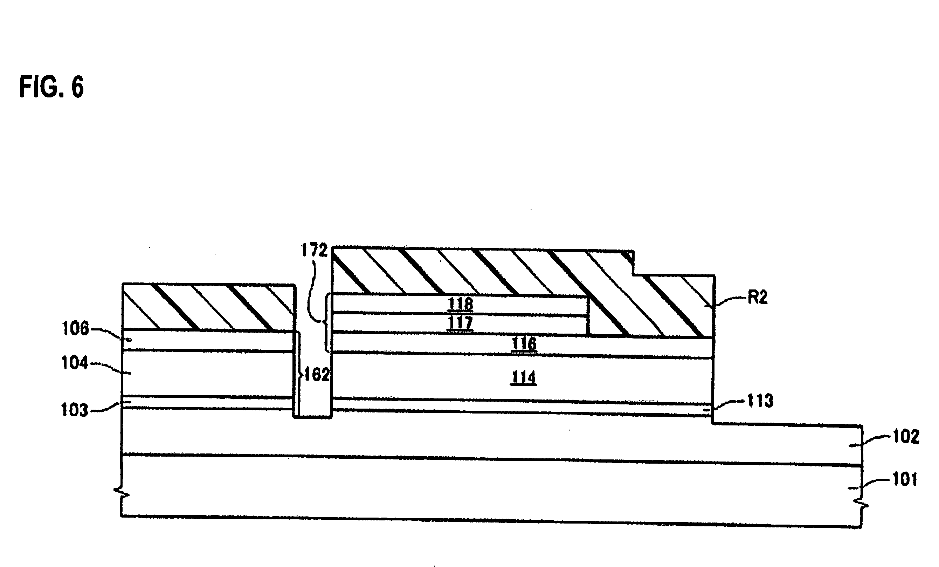

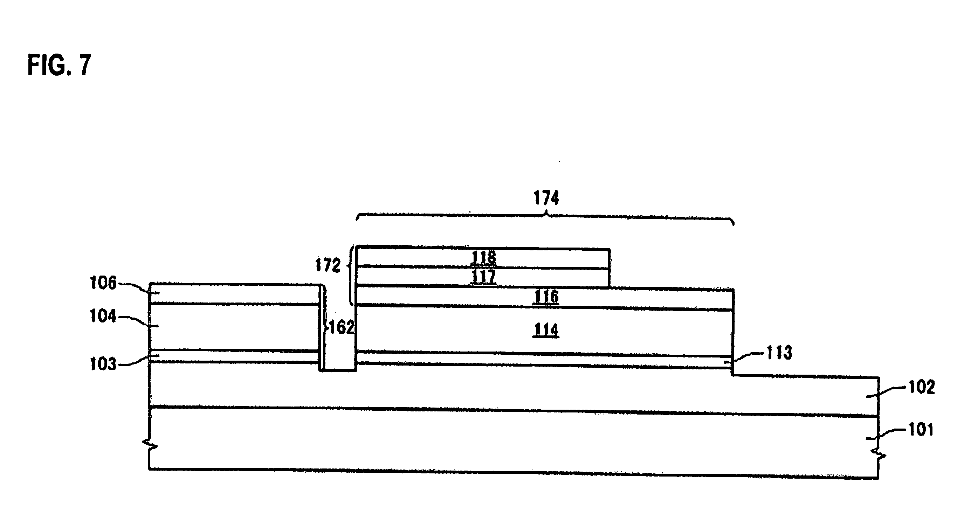

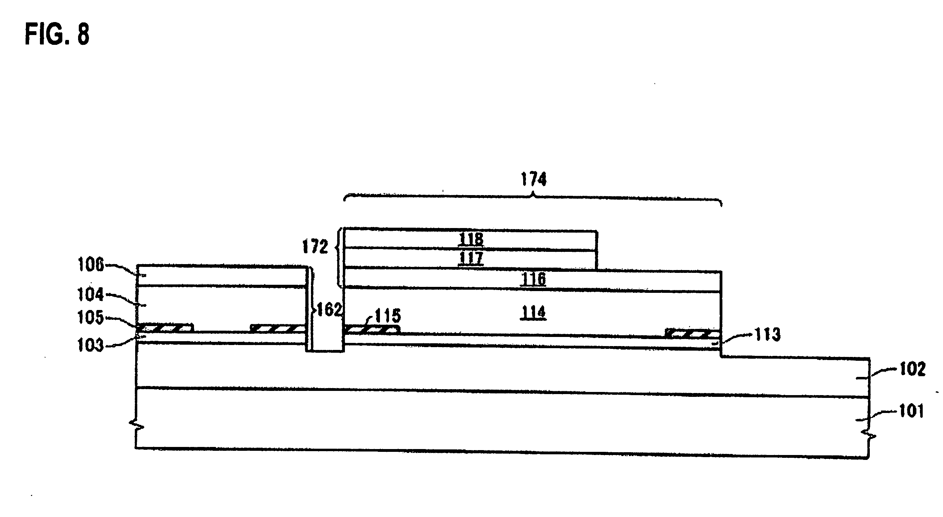

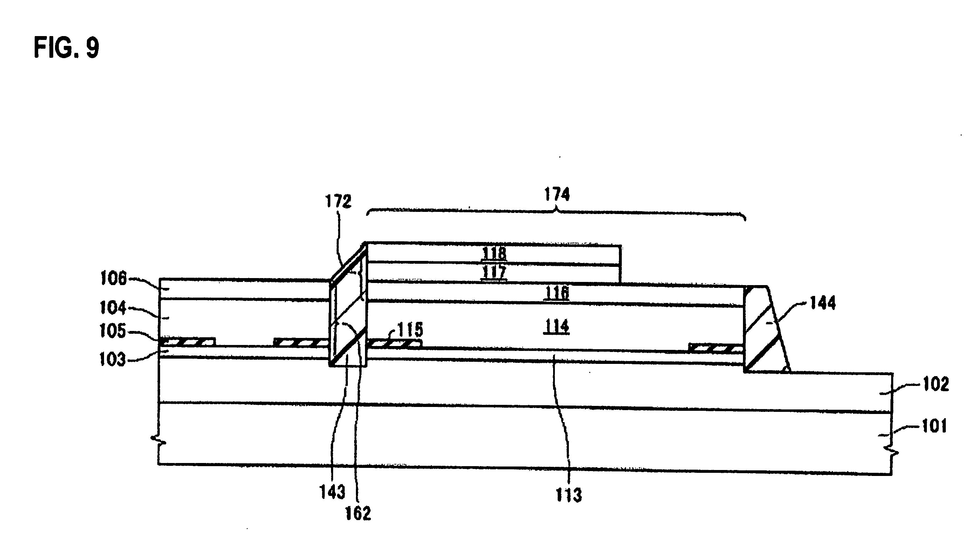

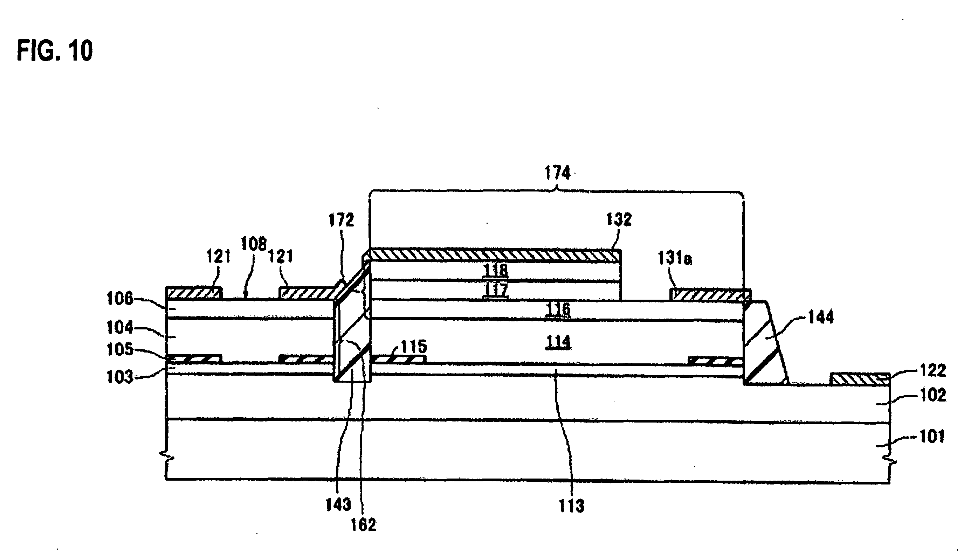

An example of a method for manufacturing the optical element 100 in accordance with an embodiment of the present invention is described with reference to FIG. 3 through FIG. 10. FIG. 3 through FIG. 10 are views showing the steps of manufacturing the optical element 100, each of which corresponds to FIG. 2.
(1) First, on the surface of a semiconductor substrate 101 composed of n-type GaAs, a semiconductor multilayer film is formed by epitaxial growth while modifying its composition, as shown in FIG. 3. It is noted here that the semiconductor multilayer film is formed from, for example, a first mirror 102a of 40 pairs of alternately laminated n-type Al_{0.9}Ga_{0.1}As layers and n-type Al_{0.15}Ga_{0.85}As layers, an active layer 103a composed of GaAs well layers and Al_{0.3}Ga_{0.7}As barrier layers in which the well layers include a quantum well structure composed of three layers, a second mirror 104a of 25 pairs of alternately laminated p-type Al_{0.9}Ga_{0.1}As layers and p-type Al_{0.15} Ga_{0.85}As layers, a first semiconductor layer 106a composed of a p-type GaAs layer, a second semiconductor layer 107a composed of a GaAs layer in which no impurity is doped, and a third semiconductor layer 108a composed of n-type GaAs layer. These layers are successively laminated on the semiconductor substrate 101 to thereby form the semiconductor multilayer film, as shown in FIG. 3.
   The temperature at which the epitaxial growth is conducted is appropriately decided depending on the growth method, the kind of raw material, the type of the semiconductor substrate 101, and the kind, thickness and carrier density of the semiconductor multilayer film to be formed, and in general may preferably be 450°C - 800°C. Also, the time required for conducting the epitaxial growth is appropriately decided like the temperature. Also, a metal-organic vapor phase growth (MOVPE: Metal-Organic Vapor Phase Epitaxy) method, a MBE method (Molecular Beam Epitaxy) method or a LPE (Liquid Phase Epitaxy) method can be used as a method for the epitaxial growth.
   It is noted that, when growing the second mirror 104a, at least one of the layers near the active layer 103a is formed to be a layer that is later oxidized and becomes a dielectric layer (see FIG. 8).
(2) Next, the third semiconductor layer 108a and the second semiconductor layer 107a are patterned in a specified configuration, thereby forming a third semiconductor layer 118 and a second semiconductor layer 117 (see FIG. 4 and FIG. 5).
   First, resist (not shown) is coated on the semiconductor multilayer film, and then the resist is patterned by a lithography method, thereby forming a resist layer R1 having a specified pattern, as shown in FIG. 4.
   Then, by using the resist layer R1 as a mask, a portion of the third semiconductor layer 108a and the second semiconductor layer 107 is etched. Then, the resist layer R1 is removed.
(3) Next, the third semiconductor layer 118, the second semiconductor layer 117, the first semiconductor layer 106a, the second mirror 104a, the active layer 103a, and a portion of the first mirror 102a are patterned in a specified configuration (see FIG. 6 and FIG. 7). Concretely, resist (not shown) is coated over the first semiconductor layer 106a, and then the resist is patterned by a lithography method, whereby a resist layer R2 having a second configuration is formed. Next, by using the resist layer R2 as a mask, etching is conducted by, for example, a dry etching method. Then, the resist layer R2 is removed.
   By this, a columnar section 172 of the rectification element 170 and a columnar section 162 of the surface-emitting type semiconductor laser 160 can be formed at the same time.
(4) Next, by placing the semiconductor substrate 101 on which the columnar section 162 of the surface-emitting type semiconductor laser 160 and the columnar section 172 of the rectification element 170 are formed through the aforementioned steps in a water vapor atmosphere at about 400°C, for example, a layer having a high AI composition provided in the above-described second mirror 104 is oxidized from its side surface, thereby forming a current constricting layer 105 (see FIG. 8) of the surface-emitting type semiconductor laser 160.
(5) Next, resin layers 143 and 144 are formed (see FIG. 9) in specified regions over the semiconductor substrate 101. The resin layers 143 and 144 may be composed of an inorganic material such as silicon nitride, silicon oxide or the like, or may be composed of another resin, such as, for example, polyimide resin, fluororesin, acrylic resin, or epoxy resin. Also, the resin layer may be provided in a plurality of layers or a single layer.
(6) Next, a first electrode 131 a, a second electrode 131b, a third electrode 132, a fourth electrode 121, and a fifth electrode 122 are formed (see FIG. 10).
   First, before forming the electrodes, electrode forming areas may be washed with a plasma treatment or the like if necessary.
   The first electrode 131a and the second electrode 131b are formed with the same material. The fourth electrode 121, the first electrode 131a and the second electrode 131b are formed from a p-type electrode material, and may be formed from, for example, a laminated layer of platinum (Pt) and gold (Au). The fifth electrode 122 and the third electrode 132 are formed from an n-type electrode material, and may be formed from, for example, a laminated film of an alloy of gold and germanium (AuGe), nickel (Ni) and gold (Au). Also, as a method for forming the electrode, for example, at least a conductive layer in a single layer may be formed by a sputter method or a vacuum deposition method, and then a part of the conductive layer may be removed by a lift-off method. It is noted that a dry etching method may be used instead of the lift-off method. An opening section of the fourth electrode 121 defines an emission surface 108 of the surface-emitting type semiconductor laser 160. Further, alignment marks 220 (see FIG. 1) may be formed concurrently with the formation of the electrodes.
(7) Next, a first connection electrode 141 and a second connection electrode 142 are formed (see FIG. 1 and FIG. 2).

The first connection electrode 141 and the second connection electrode 142 may be formed with, for example, gold (Au). As a method for forming the electrode, a forming method similar to those described above may be used.

In this manner, the optical element 100 including the rectification element 170 and the surface-emitting type semiconductor laser 160 can be formed. By this, even when a reverse bias voltage is impressed to the surface-emitting type semiconductor laser 160, the current flows to the rectification element 170, whereby the electrostatic breakdown tolerance against a reverse bias voltage is substantially improved. Accordingly, electrostatic breakdown in the mounting process and the like can be prevented, and the reliability can be improved.

It is noted that the method for manufacturing an optical element in accordance with the present embodiment contains details that can be derived from the description of the aforementioned optical element.

### 3. Modified Example

A variety of modified examples that can be derived from the description of the aforementioned optical element can be implemented in the optical element 100 in accordance with the present embodiment.

### 3.1. First Modified Example

For example, although the resin layer 143 in accordance with the present embodiment does not extend onto the contact layer 106 or the third semiconductor layer 118, as shown in FIG. 2, a part thereof may extend onto them instead of this structure. If the resin layer 143 does not extend onto the contact layer 106 or the third semiconductor layer 118, a gap may be formed between the resin layer 143 and the columnar section 162 or 172, and the electrode material may enter the gap, which may cause disconnection. Therefore, by forming the resin layer 143 with a portion thereof extending over the contact layer 106 and the third semiconductor layer 118, disconnection of the first connection electrode 141 can be prevented.

The resin layer 144 may also be formed such that it extends onto the first semiconductor layer 116 like the resin layer 143, whereby disconnection of the second connection electrode 142 can be prevented.

### 3.2. Second Modified Example

In FIG. 1, the columnar section 174 in accordance with the present embodiment has a configuration that is bent in the same direction as that of the second connection electrode 142, as viewed in a plan view, but may have a configuration that is bent in an opposite direction with respect to the second connection electrode 142.

The present invention is not limited to the embodiments described above. For example, embodiments may include compositions that are substantially the same as the compositions described in the embodiments (for example, a composition with the same function, method and result, or a composition with the same objects and result). Also, embodiments may include compositions in which portions not essential in the compositions described in the embodiment are replaced with others. Also, embodiments may include compositions that can achieve the same functions and effects or achieve the same objects of those of the compositions described in the embodiment. Furthermore, embodiments may include compositions that include publicly known technology added to the compositions described in the embodiments.

## Claims

1. An optical element comprising:
a first semiconductor element (170),
a second semiconductor element (160), wherein
the first semiconductor element includes
a semiconductor layer,
a first electrode (131a) of a first conductivity type for driving the first semiconductor element and
a third electrode (132) of a second conductivity type for driving the first semiconductor element, and
the second semiconductor element includes
a fourth electrode (121) of the first conductivity type for driving the second semiconductor element, and
a fifth electrode (122) of the second conductivity type for driving the second semiconductor element; and
a first connection electrode (142) connecting the first electrode and the fifth electrode, **characterized in that** the first semiconductor element includes a second electrode (131b) of a first conductivity type for driving the first semiconductor element, the first and second electrode being formed at mutually separated positions and above the semiconductor layer, and **in that** a second connection electrode connects the second electrode and the fifth electrode.

2. An optical element according to claim 1, wherein the first electrode and the second electrode, and the fifth electrode are formed at different heights, and the connection electrode is formed continuously over a substrate from an upper surface of the first electrode to an upper surface of the fifth electrode, and formed continuously from an upper surface of the second electrode to the upper surface of the fifth electrode.

3. An optical element according to claim 2, further comprising an insulation layer (143) formed between the first semiconductor element and the second semiconductor element, wherein the connection electrode is formed through an upper surface of the insulation layer continuously from the upper surface of the first electrode to the upper surface of the fifth electrode, and formed through the upper surface of the insulation layer continuously from the upper surface of the second electrode to the upper surface of the fifth electrode.

4. An optical element according to claim 3, wherein the first electrode and the second electrode are formed at a position higher than the fifth electrode as viewed from the side of the substrate, and the insulation layer has a side surface downwardly sloped from the side of the first electrode and the second electrode to the side of the fifth electrode.

5. An optical element according to claim 1, wherein the first electrode and the second electrode are formed on an upper surface of the semiconductor layer.

6. An optical element according to claim 5, wherein the semiconductor layer is formed in a region that does not include at least a part of a region on a virtual line connecting the first electrode and the second electrode, as viewed in a plan view.

7. An optical element according to claim 1, wherein the connection electrode is formed through a region other than a forming region of the semiconductor layer continuously from the upper surface of the first electrode to the upper surface of the second electrode.

8. An optical element according to claim 1, wherein the second semiconductor element is a surface-emitting type semiconductor laser.

9. An optical element according to claim 8, wherein the first semiconductor element is a rectification element that is electrically connected in parallel with the surface-emitting type semiconductor laser.

10. An optical element according to claim 1, wherein the second semiconductor element is a surface-emitting type semiconductor laser; and the first semiconductor element is a rectification element that is connected in parallel with the surface-emitting type semiconductor laser, wherein
the rectification element includes
a first semiconductor layer of a second conductivity type and a second semiconductor layer of a first conductivity type formed successively from the side of a substrate,
said first electrode and said second electrode of the first conductivity type formed at mutually separated positions above the second semiconductor layer, and
said third electrode of the second conductivity type, and
the surface-emitting type semiconductor laser includes
a first mirror, an active layer and a second mirror formed successively from the side of the substrate,
said fourth electrode of the first conductivity type, and
said fifth electrode of the second conductivity type; and
said first connection electrode connecting the first electrode and the fifth electrode, and said second connecting electrode connecting the second electrode and the fifth electrode.

## Patentansprüche

1. Optisches Element mit:
einem ersten Halbleiterelement (170);
einem zweiten Halbleiterelement (160), wobei
das erste Halbleiterelement enthält:
eine Halbleiterschicht,
eine erste Elektrode (131a) des ersten Leitfähigkeitstyps zum Ansteuern des ersten Halbleiterelements, und
eine dritte Elektrode (132) des zweiten Leitfähigkeitstyps zum Ansteuern des ersten Halbleiterelements,
und wobei
das zweite Halbleiterelement enthält:
eine vierte Elektrode (121) des ersten Leitfähigkeitstyps zum Ansteuern des zweiten Halbleiterelements, und
eine fünfte Elektrode (122) des zweiten Leitfähigkeitstyps zum Ansteuern des zweiten Halbleiterelements; und
eine erste Verbindungselektrode (142), die die erste und die fünfte Elektrode verbindet,
**dadurch gekennzeichnet, dass** das erste Halbleiterelement eine zweite Elektrode (131b) des ersten Leitfähigkeitstyps zum Ansteuern des ersten Halbleiterelements enthält, wobei die erste und zweite Elektrode in voneinander getrennten Positionen und über der Halbleiterschicht ausgebildet sind, und dadurch, dass eine zweite Verbindungselektrode die zweite und die fünfte Elektrode verbindet.

2. Optisches Element nach Anspruch 1, bei dem die erste Elektrode und die zweite Elektrode, und die fünfte Elektrode in verschiedenen Höhen ausgebildet sind, und die Verbindungselektrode durchgängig über ein Substrat von einer oberen Oberfläche der ersten Elektrode zu einer oberen Oberfläche der fünften Elektrode ausgebildet ist und durchgängig von einer oberen Oberfläche der zweiten Elektrode zu einer oberen Oberfläche der fünften Elektrode ausgebildet ist.

3. Optisches Element nach Anspruch 2, ferner eine Isolierschicht (143) aufweisend, die zwischen dem ersten Halbleiterelement und dem zweiten Halbleiterelement ausgebildet ist, wobei die Verbindungselektrode durch die obere Oberfläche der Isolierschicht durchgängig von der oberen Oberfläche der ersten Elektrode zur oberen Oberfläche der fünften Elektrode und durch die obere Oberfläche der Isolierschicht durchgängig von der oberen Oberfläche der zweiten Elektrode zur oberen Oberfläche der fünften Elektrode ausgebildet ist.

4. Optisches Element nach Anspruch 3, bei dem die erste und die zweite Elektrode bei Betrachtung von der Substratseite aus in einer höheren Position als die fünfte Elektrode ausgebildet sind, und die Isolierschicht eine von der Seite der ersten und der zweiten Elektrode zur Seite der fünften Elektrode nach unten geneigte Seitenfläche hat.

5. Optisches Element nach Anspruch 1, bei dem die erste und die zweite Elektrode auf einer oberen Oberfläche der Halbleiterschicht ausgebildet sind.

6. Optisches Element nach Anspruch 5, bei dem die Halbleiterschicht, in der Draufsicht, in einem Bereich ausgebildet ist, der nicht zumindest einen Teil eines Bereichs auf einer die erste Elektrode und die zweite Elektrode verbindenden gedachten Linie enthält.

7. Optisches Element nach Anspruch 1, bei dem die Verbindungselektrode durch einen anderen Bereich als den Formbereich der Halbleiterschicht durchgängig von der oberen Oberfläche der ersten Elektrode zur oberen Oberfläche der zweiten Elektrode ausgebildet ist.

8. Optisches Element nach Anspruch 1, bei dem das zweite Halbleiterelement ein Halbleiterlaser des oberflächenemittierenden Typs ist.

9. Optisches Element nach Anspruch 8, bei dem das erste Halbleiterelement ein Gleichrichterelement ist, das elektrisch parallel zum Halbleiterlaser des oberflächenemittierenden Typs geschaltet ist.

10. Optisches Element nach Anspruch 1, bei dem das zweite Halbleiterelement ein Halbleiterlaser des oberflächenemittierenden Typs und das erste Halbleiterelement ein Gleichrichterelement ist, das parallel zum Halbleiterlaser des oberflächenemittierenden Typs geschaltet ist, wobei
das Gleichrichterelement enthält:
eine erste Halbleiterschicht des zweiten Leitfähigkeitstyps und eine zweite Halbleiterschicht des ersten Leitfähigkeitstyps, die nacheinander von der Seite eines Substrats aus ausgebildet sind,
wobei die erste Elektrode und zweite Elektrode des ersten Leitfähigkeitstyps, die in voneinander getrennten Positionen über der zweiten Halbleiterschicht ausgebildet sind, und
die dritte Elektrode des zweiten Leitfähigkeitstyps, und
der Halbleiterlaser des oberflächenemittierenden Typs enthält:
einen ersten Spiegel, eine aktive Schicht und einen zweiten Spiegel, die nacheinander von der Seite des Substrats aus ausgebildet sind,
die vierte Elektrode des ersten Leitfähigkeitstyps, und
die fünfte Elektrode des zweiten Leitfähigkeitstyps, und
die erste Verbindungselektrode, die die erste und die fünfte Elektrode verbindet, sowie die zweite Verbindungselektrode, die die zweite und die fünfte Elektrode verbindet.

## Revendications

1. Elément optique comprenant:
un premier élément (170) à semiconducteur,
un deuxième élément (160) à semiconducteur, dans lequel le premier élément à semiconducteur comprend:
une couche semi-conductrice,
une première électrode (131a) d'un premier type de conductivité, pour commander le premier élément à semiconducteur et
une troisième électrode (132) d'un deuxième type de conductivité, pour commander le premier élément à semiconducteur, et
le deuxième élément à semiconducteur comprend
une quatrième électrode (121) du premier type de conductivité, pour commander le deuxième élément à semiconducteur,
une cinquième électrode (122) du deuxième type de conductivité, pour commander le deuxième élément à semiconducteur; et
une première électrode (142) de connexion, reliant la première électrode et la cinquième électrode,
**caractérisé en ce que** le premier élément à semiconducteur comprend une deuxième électrode (131 b) d'un premier type de conductivité, pour commander le premier élément à semiconducteur, la première et la deuxième électrode étant formée en des positions mutuellement à distance et au dessus de la couche semiconductrice et **en ce qu'**une deuxième électrode de connexion relie la deuxième électrode et la cinquième électrode.

2. Elément optique suivant la revendication 1, dans lequel la première électrode, la deuxième électrode et la cinquième électrode sont formées à des hauteurs différentes et l'électrode de connexion est formée continûment sur un substrat en allant d'une surface supérieure de la première électrode à une surface supérieure de la cinquième électrode, et est formé continûment en allant d'une surface supérieure de la deuxième électrode à la surface supérieure de la cinquième électrode.

3. Elément optique suivant la revendication 2, comprenant en outre une couche (143) isolante formée entre le premier élément à semiconducteur et le deuxième élément à semiconducteur, l'électrode de connexion étant formée à travers une surface supérieure de la couche isolante continûment en allant de la surface supérieure de la première électrode à la surface supérieure de la cinquième électrode, et étant formée à travers la surface supérieure de la couche isolante continûment en allant de la surface supérieure de la deuxième électrode à la surface supérieure de la cinquième électrode.

4. Elément optique suivant la revendication 3, dans lequel la première électrode et la deuxième électrode sont formées en une position plus haute que la cinquième électrode telle que vu depuis le coté du substrat et la couche isolante a une surface latérale inclinée vers le bas à partir du côté de la première électrode et de la deuxième électrode vers le côté de la cinquième électrode.

5. Elément optique suivant la revendication 1, dans lequel la première électrode et la deuxième électrode sont formées sur une surface supérieure de la couche semi-conductrice.

6. Elément optique suivant la revendication 5 dans lequel la couche semi-conductrice est formée dans une région qui ne comprend pas au moins une partie d'une région sur une ligne virtuelle reliant la première électrode et la deuxième électrode, tel que vu dans une vue en plan.

7. Elément optique suivant la revendication 1, dans lequel l'électrode de connexion est formée à travers une région autre qu'une région de formation de la couche semiconductrice continûment en allant de la surface supérieure de la première électrode à la surface supérieure de la deuxième électrode.

8. Elément optique suivant la revendication 1 dans lequel le deuxième élément à semiconducteur est un laser à semiconducteur du type à émission par la surface.

9. Elément optique suivant la revendication 8 dans lequel le premier élément à semiconducteur est un élément redresseur qui est monté électriquement en parallèle avec le laser à semiconducteur du type à émission par la surface.

10. Elément optique suivant la revendication 1 dans lequel le deuxième élément à semiconducteur est un laser à semiconducteur du type à émission par la surface et le premier élément à semiconducteur est un élément redresseur qui est monté en parallèle avec le laser à semiconducteur à émission par la surface, dans lequel
l'élément redresseur comprend
une première couche semiconductrice d'un deuxième type de conductivité et une deuxième couche semiconductrice d'un premier type de conductivité formées successivement à partir du côté d'un substrat,
la première électrode et la deuxième électrode du premier type de conductivité formées en des positions mutuellement séparées au dessus de la deuxième couche semi-conductrice, et
la troisième électrode du deuxième type de conductivité, et
le laser à semiconducteur de type à émission par la surface comprend
un premier miroir, une couche active et un deuxième miroir formés successivement à partir du côté du substrat,
la quatrième électrode du premier type de conductivité, et
la cinquième électrode du deuxième type de conductivité, et
la première électrode de connexion reliant la première électrode et la cinquième électrode et la deuxième électrode de connexion reliant la deuxième électrode et la cinquième électrode.
